# EUROPEAN PATENT SPECIFICATION

(11) **EP 0 782 178 B1**
(45) Date of publication and mention of the grant of the patent: **26.09.2001**
(21) Application number: 96309287.9
(22) Date of filing: 19.12.1996
(51) Int. Cl.: H01L 21/20

(54) **Solid phase epitaxial crystallization of amorphous silicon films on insulating substrates**
Kristallisation von amorphen Siliziumschichten auf nichtleitenden Substraten durch Festphasenepitaxie
Cristallisation épitaxiale en phase solide des couches de silicium amorphe sur substrat isolant

(30) Priority: 26.12.1995 US 578809; 26.12.1995 US 578810
(43) Date of publication of application: 02.07.1997
(73) Proprietor: XEROX CORPORATION, Rochester, New York 14644 (US)
(72) Inventor: King, Tsu-Jae, Cupertino, California 95014 (US); Ho, Jackson H., Palo Alto, California 94301 (US)
(74) Representative: Grünecker, Kinkeldey, Stockmair & Schwanhäusser Anwaltssozietät

(56) References cited:
- US-A- 5 147 826
- JPN. J. APPL. PHYS. 2, LETT., vol. 34, no. 8B, 15 August 1995, pages L1031-L1033, XP000617839 R. MYUNG-KWAN, K. JIN-WON, K. TAE-HOON, K. KI-BUM, H. CHANG-WON: "Reducing the thermal budget of solid phase crystallization of amorphous Si film using Si0.47Ge0.53 seed layer"
- JAPANESE JOURNAL OF APPLIED PHYSICS, vol. 32, no. 9A, PART 01, 1 September 1993, pages 3720-3728, XP000487535 MATSUYAMA T ET AL: "IMPROVEMENT OF N-TYPE POLY-SI FILM PROPERTIES BY SOLID PHASE CRYSTALLIZATION METHOD"

## Description

This invention relates generally to thin film transistors and more particularly concerns a process in which high quality polysilicon films are produced at reduced temperatures compared to traditional methods of producing polysilicon films.

Polycrystalline silicon (polysilicon) thin-film transistors (TFTs) are important for a variety of large-area electronics applications due to their superior performance compared to amorphous silicon (α-Si) TFTs. Presently, the preferred method for obtaining high-quality polysilicon films with low surface roughness and high structural perfection on insulating substrates (e.g., oxide, quartz, glass) is by amorphous-phase deposition and subsequent thermal annealing. The crystallization process typically requires either annealing at temperatures ranging from 550°C to 600°C for periods of time greater than 2 hours or rapid (less than 1 second) thermal annealing at much higher temperatures of approximately 800°C. This relatively large "thermal budget" required for crystallization is incompatible with large-area glass substrates, which cannot withstand prolonged exposure to temperatures much higher than 600°C due to warpage and shrinkage problems.

The crystallization of an α-Si film on an insulating substrate is limited by two processes. These two limiting processes are grain nucleation and grain growth. Nucleates must form before grain growth can take place. Nucleates will form primarily at the lower interface between the α-Si and the substrate. Once the nucleates have been formed, grain growth proceeds from the nucleating sites, both in the lateral direction (parallel to the interface) and the vertical direction (perpendicular to the interface). Since polysilicon films suitable for high performance TFT applications are typically less than 100 nm thick, with average grain sizes greater than 100 nm, the lateral grain growth rather than the vertical grain growth is the limiting step in the crystallization process.

A process having the features of the preamble of claim 1 is disclosed in US-A-5147826.

"Japanese Journal of Applied Physics," Volume 34, by R. Myung-Kwan et al., "Reducing the thermal budget of solid phase crystallization of amorphous Si film using Si_{0.47}Ge_{0.53} seed layer," discloses a a-Si crystallization process using a layer of Si₁₋ₓGeₓ as a seed layer.

It is the object of the invention to provide a method of crystallization of polysilicon films which require lower temperatures and shorter times than traditional annealing processes.

This object is achieved with a process having the features of claim 1.

In the method, crystallization occurs by epitaxial growth from an adjacent polycrystalline film. In this manner, growth is limited only by the vertical (solid-phase) crystallization rate, rather than the grain-nucleation rate and lateral-growth rate. Significant improvements in process throughput and reductions in annealing temperature are achievable for the crystallization process. These improvements mitigate the glass-substrate warpage and shrinkage problems with the older processes due to either long annealing times or high annealing temperatures.

Preferable embodiments form the subject matter of the dependent claims.

Briefly stated and in accordance with the present invention, there is provided a new method of crystallization, using polycrystalline silicon-germanium (poly-Si₁₋ₓGeₓ, where ₓ is some number greater than zero but less than or equal to 1) capping films to "seed" crystallization of α-Si films. Once the capping film is in place crystallization occurs at lower temperatures and requires less time than in traditional methods. After crystallization has occurred the polycrystalline silicon-germanium (poly-Si₁₋ₓGeₓ) capping film can be easily and selectively removed.

Figure 1 shows a cross-sectional view of a substrate after deposition of an amorphous silicon film.

Figure 2 shows the substrate of Figure 1 after deposition of a polycrystalline seed film.

Figure 3 shows the substrate of Figure 2 after the processing step of crystallization annealing.

Figure 4 shows the substrate of Figure 3 after removal of the polycrystalline seed film.

An initial study to demonstrate the feasibility and the advantages of this new method, using polycrystalline silicon-germanium (poly-Si₁₋ₓGeₓ) capping films to "seed" crystallization of α-Si films was performed. Physical phenomena such as crystallization occur at lower temperatures for Si₁₋ₓGeₓ than for Si, therefore, Si₁₋ₓGeₓ is deposited in polycrystalline form at temperatures typically used for α-Si deposition and crystallization, approximately 550°C but within the range of 250°C to 600°C.

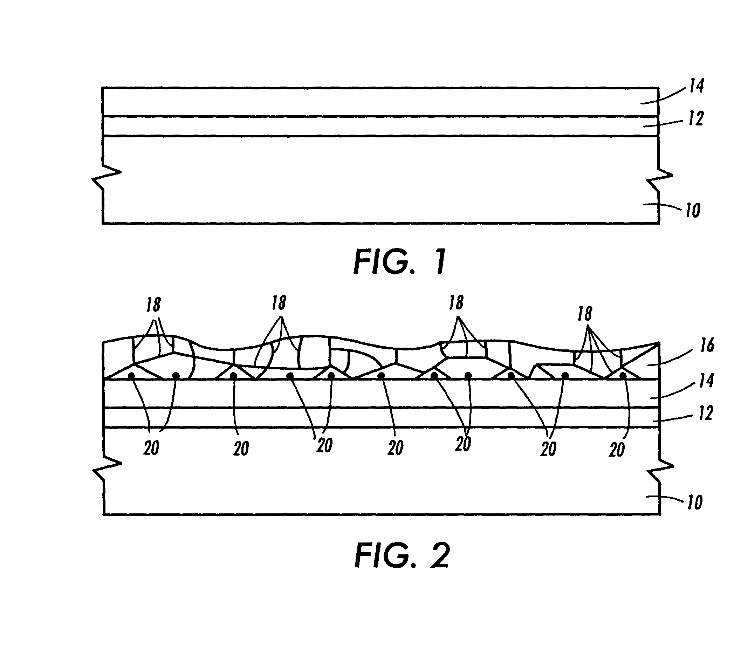

Two sets of wafers 10 (each consisting of 5 quartz wafers and 6 silicon wafers) were prepared as shown in Figure 1 and a set of wafers 10 used to establish an experimental control case. In the control set, the α-Si 14 was not capped. All three sets of the wafers 10 were first coated with SiO₂ 12, as an insulating layer, and annealed. The SiO₂ 12 was approximately 700 nm thick but thicknesses ranging from 0 nm (for quartz or glass substrates) to 1000 nm can be used. Afterwards, α-Si 14 and a capping seed layer 16, were deposited in a conventional low-pressure chemical-vapor deposition (LPCVD) system as shown in Figure 2. The α-Si 14 deposition conditions used for each set of wafers 10 were identical. Temperature was kept at approximately 550°C with deposition times of approximately 1 hour at a pressure of approximately 100 millitorr. These conditions were found to yield an approximately 86 nm-thick α-Si 14 film.

For the first set of experimental wafers 10, the Ge source gas (GeH₄) was turned on for approximately 5 minutes immediately following the α-Si 14 deposition step with the Si source gas (SiH₄), to deposit a capping layer of poly-Si_{0.4}Ge_{0.6} as a capping seed layer 16. For the second set of experiental wafers 10, the Si source gas (SiH₄) was turned off immediately after the α-Si 14 deposition step, and the Ge source gas (GeH₄) was turned on for 5 minutes, to deposit a capping seed layer 16 of polycrystalline germanium (poly-Ge).

It should be noted that, for a given deposition temperature, the deposition rate of Si₁₋ₓGeₓ is significantly higher than that of silicon and increases with the increasing amount of germanium present. Therefore, a capping layer of poly-Si₁₋ₓGeₓ can be deposited in a very short amount of time. The thickness of a capping seed film 16 of poly-Si_{0.4}Ge_{0.6} and poly-Ge films in this study are greater than 100 nm. Preferably, the thickness of the capping seed film 16 should be within the range of 5 nm to 500 nm thick.

Grain boundaries 18 and nucleation sites 20 can be seen in the capping seed layer 16. The arrangement of the grain boundaries 18 and the nucleation sites 20 is typical of deposited crystalline structure or a crystalline structure produced with a traditional annealing technique. Notice that near the boundary between the α-Si 14 and the capping seed layer 16, the grain boundaries 18 appear random indicating that crystallization started in this region of the capping seed layer 14 with many nucleation sites 20. As the capping seed layer 16 grew upward from the α-Si 14 the grain boundaries 18 become more orderly and there are no more nucleation sites 20. Analysis of a crystal for nucleation sites 20 and grain boundaries 18 can therefore identify where in the crystalline structure crystal growth began and in what direction the crystal grew.

While these experiments were done by depositing a capping seed layer 16 of either poly-Si_{0.4}Ge_{0.6} or polycrystalline germanium, other alternatives are available for use as a capping seed layer 16. The capping seed layer 16 could be deposited in an amorphous rather than a crystalline form. Because germanium and silicon germanium compounds anneal and crystallize at much lower temperatures than the silicon, it is possible to deposit the capping seed layer 16 in an amorphous state with crystallization of the capping seed layer 16 occurring first as part of the annealing and crystallization process step. Once the capping seed layer 16 has then crystallized the α-Si 14 will also crystallize in the same manner as in these experiments.

Another variation in the capping seed layer is to deposit a layer, either amorphous or crystalline, of Si₁₋ₓGeₓ that has a graded concentration of germanium throughout the capping seed layer 16. This would be done to improve lattice mismatch between silicon and the capping layer. The lattic mismatch between silicon and germanium is about 4%. To promote efficient epitaxial growth, lattice mismatch should be kept below approximately 2%. Therefore, the germanium content in a graded capping seed layer 16 should be at its lowest at the interface between the α-Si 14 and the capping seed layer 16 to promote epitaxial growth of a high quality silicon film. The germanium content elsewhere in the capping seed layer 16 can be greater to promote rapid crystallization at lower annealing temperatures.

Crystallization experiments were first carried out in a very rapid thermal processing (VRTP) xenon arc-lamp system along with a pre-heating step, in order to approximately determine the magnitude of the reduction in crystallization temperature achievable with the new method. The capping seed layer 16 of poly-Si₁₋ₓGeₓ was found to absorb the arc-lamp power more efficiently than α-Si 14, so that a lower pre-heat temperature and/or lower lamp power could be used. The more efficient absorption of lamp energy by Si₁₋ₓGeₓ allows the capping seed layer 16 to heat up faster as well as to promote epitaxial growth. For example, a pre-heat temperature of 445°C and lamp power of 14 kW was required in order to heat the uncapped α-Si 12 samples to 650°C, compared to the 353°C and 11 kW required for α-Si 12 samples with a capping seed layer 16 polycrystalline germanium. Thus, for a VRTP crystallization process, an additional benefit of the poly-Si₁₋ₓGeₓ capping seed layer 16 is reduced power consumption.

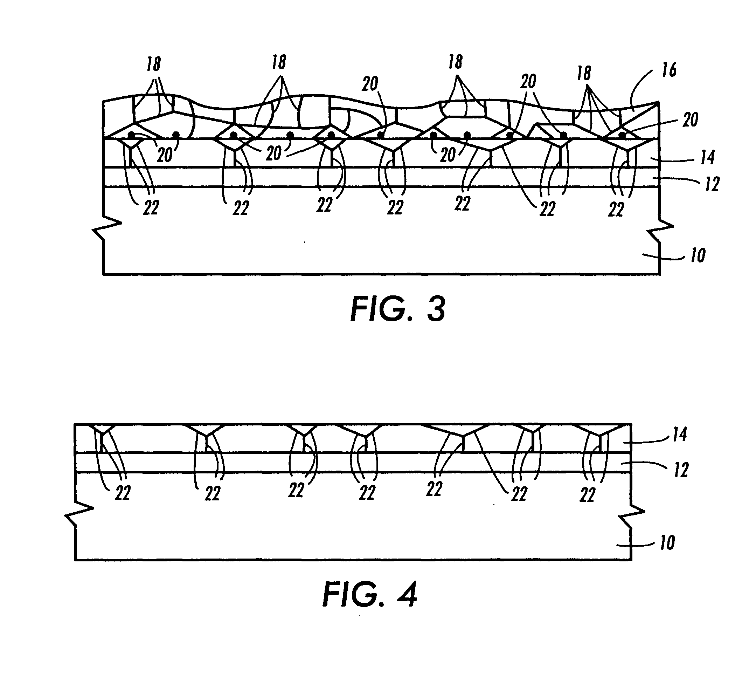

The quartz wafers 10, from all three sets of samples, then underwent very rapid (2-second) thermal annealing as shown in Figure 3. For the control set of samples, the annealing temperatures ranged from 647°C to 660°C; for the first set of experimental samples, they ranged from 625°C to 650°C; and for the second set of experimental samples, they ranged from 570°C to 654°C.

These overlapping temperature ranges were chosen to allow comparisons of capped Si films with uncapped Si films that were annealed at the same temperature. The uncapped α-Si films required an anneal temperature of greater than 645°C for crystallization. The α-Si 14 with a capping seed layer 16 of Si_{0.4}Ge_{0.6} required approximately 620°C for crystallization. Crystallization is evidenced by a change in the color and the transparency of the α-Si 14 film. The α-Si 14 films with a capping seed layer 16 of poly-Ge were found to crystallize at 570°C. These results verify that the crystallization temperature can be lowered by using a polycrystalline capping seed layer 16. Because the strain point of commercially available large-area glass substrates is approximately 630°C, this method allows a high-throughput, glass-compatible crystallization process to be realized.

The relationship between crystallization time and crystallization temperature is expected to vary for the capping layer crystallization process as it does for conventional processes. In the conventional process there is roughly an inverse logarithmic relationship between crystallization time and crystallization temperature. For instance, reducing the temperature by 100 degrees C multiplies the time needed for crystallization by approximately 10. This is not an exact calculation but merely an approximation. It is expected that this approximate relationship between crystallization time and crystallization temperature will also apply to the new crystallization process described herein.

For instance, the experiments carried out have shown that α-Si 14 films with a capping seed layer 16 of poly-Ge were found to crystallize at 570°C with a 2 second annealing process, therefore, applying the time/temperature relationship from the conventional process, α-Si 14 films with a capping seed layer 16 of poly-Ge should also crystallize at 470°C in a 20 second annealing process. Alternatively, the time for crystallization should be reduced to one tenth of 2 seconds in a 670°C annealing process.

Similarly, if α-Si 14 with a capping seed layer 16 of Si_{0.4}Ge_{0.6} required approximately 620°C for crystallization in a 2 second process then a process at 520°C and 20 seconds should also be sufficient for crystallization. Alternatively, the time for crystallization should be reduced to one tenth of 2 seconds in a 720°C annealing process.

After the samples were crystallized as shown in Figure 3, the poly-Si_{0.4}Ge_{0.6} or poly-Ge capping seed layers 16 were etched away on two wafers, one each taken from the two experimental samples, in a standard "511" bath (a H₂O:H₂O₂:NH₄OH, 5:1:1 bath which is used in the standard "RCA" wafer-cleaning process) as shown in Figure 4. An etch time of only a few minutes was found to be sufficient for complete removal of the capping seed layer 16. The thickness of the polysilicon film 14 that had a capping seed layer 16 of poly-Si_{0.4}Ge_{0.6} was measured to be approximately 80 nm, while that of the polysilicon film 14 that had a capping seed layer 16 of polygermanium was measured to be 84 nm. These results verifv that minimal germanium diffusion occurs during the crystallization process, and that poly-Si₁₋ₓGeₓ can be selectively removed by a simple wet-etch process. Germanium diffusion is manifested in a reduction in the remaining polysilicon 14 thickness, because any intermediate layer of Si₁₋ₓGeₓ which resulted from Ge diffusion is etched away in the "511" bath.

One wafer annealed at 645°C was taken from each set of samples for X-ray diffraction (XRD) analysis. Peaks were observed in the XRD spectra for each of the Si films. The peak intensities were relatively weak, however, due to the thinness of the films. Both the control sample and the sample that had a capping seed layer 16 of poly-Ge exhibited only one peak corresponding to the {111} plane spacing in Si. In contrast, the sample that had been capped with poly-Si_{0.4}Ge_{0.6} exhibited two peaks, corresponding to the {111} and {220} plane spacings in Si.

Another wafer, taken from the first experiemental sample, which was annealed at 650°C, and which did not have the capping layer of poly-Si_{0.4}Ge_{0.6} removed, was taken for additional XRD analysis. This sample exhibited four peaks, corresponding to the {111} and {220} plane spacings in the underlying Si film and in the capping Si_{0.4}Ge_{0.6} film.

A wafer, taken from the second set of experimental samples, which was annealed at 646°C, and which did not have the capping seed layer 16 of poly-Ge removed, was taken for additional XRD analysis. This sample exhibited two peaks, corresponding to the {111} plane spacings in the underlying Si film and in the capping Ge film.

These results demonstrate that the texture or preferred orientation of the capping seed film 16 is replicated in the underlying silicon film 14 or that the crystallization of the silicon film 14 occurs epitaxially from the capping seed layer 16.

It should also be noted that the grain boundaries 18 and nucleation sites 20 in the capping seed layer 16 were replicated as grain boundaries 22 in the crystallized silicon 24 with crystallization starting at the boundary of the α-Si 14 and the capping seed layer 16 and crystal growth proceeding in a direction away from the boundary. This is distinctly different from crystallization of the α-Si 14 if it had occurred in a traditional annealing and crystallization process. In a traditional process, there would be nucleation sites near the interface between the SiO₂ 12 and the α-Si 14 with crystal growth occurring away from the SiO₂ 12 and α-Si 14 boundary. The distinctive pattern including absence of nucleation sites near the α-Si 14 and capping seed layer 16 boundary shows that crystallization of the α-Si 14 occurs epitaxially from the capping seed layer 16.

The sample that had a capping seed film 16 of poly-Si_{0.4}Ge_{0.6} was analyzed by atomic-force microscopy (AFM), in a scanning-probe microscope. The root-mean-square (rms) surface roughness was measured to be 16Å, and average grain size was estimated to be 150 nm. In comparison the rms roughness of conventional (uncapped) furnace-crystallized Si films is 20Å or higher, and the average grain size in VRTP crystallized Si films is typically less than 50 nm. These results show that the epitaxial-crystallization method can provide polysilicon films 14 with relatively smooth surfaces and reasonably sized grains which are critical for achieving high-performance in top-gated thin film transistors (TFTs). Smooth surfaces and large grain sizes are important because roughness degrades effective carrier mobilities and enhances degradation due to electrical stress. It is anticipated that the performance of top-gated thin film transistors made in thin film silicon produced by the capping and crystallizing process disclosed in this application will be superior to the performance of top-gated thin film transistors made in thin film silicon produced in conventional processes due to the the superior characteristics of the thin film silicon, included reduced surface roughness and larger grain sizes.

The experiments have shown advantages to be gained by the disclosed process without adding much additional process complexity or time. Implementation of the EC method using poly-Si₁₋ₓGeₓ as a capping seed layer 16 introduces minimal additional process complexity and time because the capping seed layer 16 of Si₁₋ₓGeₓ is deposited in-situ immediately after the α-Si 14. Once the poly-Si 14 has been crystallized in the annealing step, as shown in Figure 3, the capping seed layer 16 is easily removed in a readily available wet-cleaning bath. Removal of the capping seed layer 16 is important because it leaves a clean layer of thin film polysilicon for use in fabricating thin film transistors. Impurities or other layers in the thin film polysilicon will degrade performance of the thin film transistors produced within the thin film polysilicon layer.

First the "thermal budget" required for crystallization of an α-Si 14 film can be considerably lowered by using a capping seed layer 16 of a polycrystalline Si₁₋ₓGeₓ film and using an epitaxial crystallization (EC) method. Lowering the "thermal budget" helps to achieve compatibility with glass substrates and to improve process throughput.

Second, the EC process produces poly-Si 14 films with low surface roughness and reasonable grain sizes.

Third, the thickness and structural uniformities of polysilicon films obtained with the EC method are good because the capping film is deposited in-situ and the crystallization anneal is performed either in a conventional furnace or RTP system. In the EC process, crystallization occurs by epitaxial growth rather than by semi-random grain nucleation and subsequent grain growth. The EC method therefore provides a means to control and optimize polysilicon 14 texture. With a poly-Si₁₋ₓGeₓ capping seed layer 16, the preferred grain orientation in the capping seed layer 16 and in the underlying silicon film 14 can be adjusted by changing its germanium content.

## Claims

1. An epitaxial crystallization process comprising the steps of
a) providing a substrate (10) with an upper and lower surface
b) depositing a layer (14) of amorphous silicon on the upper surface of the substrate,
c) depositing a capping seed layer (16) on the amorphous silicon layer, and
d) annealing to crystallize the amorphous silicon layer (14),
**characterized in that**
the capping seed layer (16) comprises Si₁₋ₓGeₓ, where x is any number greater than zero but less than 1, wherein the capping seed layer has a graded concentration of germanium throughout the layer (16) with the lowest concentration at the interface between the amorphous silicon layer and the capping seed layer, and
the capping seed layer (16) is removed after the annealing process.

2. A process according to Claim 1 wherein said substrate (10) comprises a material selected from the group consisting of quartz and glass.

3. A process according to Claim 1 wherein said substrate (10) comprises silicon with an insulating material layer (12) at the upper surface in contact with the amorphous silicon layer (14).

4. A process according to Claim 3 wherein said insulating material layer (12) comprises silicon dioxide.

5. A process according to any of Claims 1 to 4 wherein the capping seed layer (16) is crystalline.

6. A process according to any of Claims 1 to 4 wherein the capping seed layer (16) is amorphous and crystallizes during the annealing step, but prior to crystallization of the amorphous silicon.

7. A process according to any of Claims 1 to 6 wherein the step of annealing occurs at a temperature of below 650°C for a period of from 1 to 3 seconds, preferably 2 seconds.

8. A thin film silicon crystal obtainable from the epitaxial crystallization process in accord with any of Claims 1 to 7.

## Patentansprüche

1. Epitaxiales Kristallisationsverfahren mit den Schritten:
a) Bereitstellen eines Substrats (10) mit einer oberen und einer unteren Oberfläche
b) Abscheiden einer Schicht (14) aus amorphem Silicium an der oberen Oberfläche des Substrats,
c) Abscheiden einer Deckkeimbildungsschicht (16) auf der amorphen Siliciumschicht, und
d) Ausheizen, um die amorphe Siliciumschicht (14) zu kristallisieren,
**dadurch gekennzeichnet, dass**
die Deckkeimbildungsschicht (16) Si₁₋ₓGeₓ umfasst, wobei x eine beliebige Zahl größer als Null und kleiner oder gleich 1 ist, und wobei die Deckkeimbildungsschicht eine sich allmählich ändernde Konzentration an Germanium über die Schicht (16) besitzt, wobei die geringste Konzentration an der Grenzfläche zwischen der amorphen Siliciumschicht und der Deckkeimbildungsschicht auftritt, und
die Deckkeimbildungsschicht (16) nach dem Ausheizvorgang entfernt wird.

2. Ein Verfahren nach Anspruch 1, wobei das Substrat (10) Quarz oder Glas als Material umfasst.

3. Ein Verfahren nach Anspruch 1, wobei das Substrat (10) Silicium mit einer isolierenden Materialschicht (12) an der oberen Oberfläche umfasst, die mit der amorphen Siliciumschicht (14) in Kontakt ist.

4. Ein Verfahren nach Anspruch 3, wobei die isolierende Materialschicht (12) Siliciumdioxid umfasst.

5. Ein Verfahren nach einem der Ansprüche 1 bis 4, wobei die Deckkeimbildungsschicht (16) kristallin ist.

6. Ein Verfahren nach einem der Ansprüche 1 bis 4, wobei die Deckkeimbildungsschicht (16) amorph ist und während des Ausheizschrittes aber vor der Kristallisation des amorphen Silicium kristallisiert.

7. Ein Verfahren nach einem der Ansprüche 1 bis 6, wobei der Schritt des Ausheizens eine Temperatur unter 650°C für eine Dauer von 1 bis 3 Sekunden, vorzugsweise 2 Sekunden stattfindet.

8. Dünnfilm-Siliciumkristall, der mittels des epitaxialen Kristallisationsverfahrens nach einem der Ansprüche 1 bis 7 hergestellt ist.

## Revendications

1. Procédé de cristallisation épitaxiale comprenant les étapes consistant à
a) fournir un substrat (10) avec une surface supérieure et inférieure
b) déposer une couche (14) de silicium amorphe sur la surface supérieure du substrat
c) déposer une couche de semence de couverture (16) sur la couche de silicium amorphe, et
d) recuire pour cristalliser la couche de silicium amorphe (14),
**caractérisé en ce que**
la couche de semence de couverture (16) comprend Si₁₋ₓGeₓ, dans laquelle x et tout nombre quelconque supérieur à zéro mais inférieur à 1, dans lequel la couche de semence de couverture a une concentration graduée de germanium sur toute l'épaisseur de la couche (16) avec la concentration la plus basse au niveau de l'interface entre la couche de silicium amorphe et la couche de,semence de couverture, et
la couche de semence de couverture (16) est enlevée après le traitement de recuit.

2. Procédé selon la revendication 1, dans lequel ledit substrat (10) comprend un matériau choisi dans le groupe qui est constitué de quartz et du verre.

3. Procédé selon la revendication 1, dans lequel ledit substrat (10) comprend du silicium avec une couche de matériau isolant (12) au niveau de la surface supérieure en contact avec la couche de silicium amorphe (14).

4. Procédé selon la revendication 3, dans lequel ladite couche de matériau isolant (12) comprend du dioxyde de silicium.

5. Procédé selon l'une quelconque des revendications 1 à 4, dans lequel ladite couche de semence de couverture (16) est cristalline.

6. Procédé selon l'une quelconque des revendications 1 à 4, dans lequel ladite couche de semence de couverture (16) est amorphe et se cristallise pendant l'étape de recuit, mais avant la cristallisation du silicium amorphe.

7. Procédé selon l'une quelconque des revendications 1 à 6, dans lequel l'étape de recuit se produit à une température au-dessous de 650 °C pendant une durée de 1 à 3 secondes, de préférence 2 secondes.

8. Une cristal de silicium à film mince que l'on peut obtenir à partir du procédé de cristallisation épitaxiale selon l'une quelconque des revendications 1 à 7.
